# EUROPÄISCHE PATENTSCHRIFT

(11) **EP 0 858 963 B1**
(45) Veröffentlichungstag und Bekanntmachung des Hinweises auf die Patenterteilung: **14.07.1999**
(21) Anmeldenummer: 97121916.7
(22) Anmeldetag: 12.12.1997
(51) Int. Cl.: B65G 47/90, C23C 14/50

(54) **Vorrichtung zum Halten eines flachen Substrats**
Device for retaining a flat substrate
Dispositif pour retenir un substrat plat

(30) Priorität: 13.02.1997 DE 19705394
(43) Veröffentlichungstag der Anmeldung: 19.08.1998
(73) Patentinhaber: Leybold Systems GmbH, D-63450 Hanau am Main (DE)
(72) Erfinder: Schüssler, Uwe, 63839 Kleinwallstadt (DE); Krämer, Harald, 63538 Grosskrotzenburg (DE); Bangert, Stefan, 36396 Steinau (DE); König, Michael, 60529 Frankfurt (DE)

(56) Entgegenhaltungen:
- DE-U- 9 307 263
- US-A- 4 984 531
- US-A- 5 669 652

## Beschreibung

Die Erfindung betrifft eine Vorrichtung zum Halten eines flachen, vorzugsweise kreisscheibenförmigen Substrats mit einer zentralen Öffnung, einer sogenannten Compact Disc, bestehend aus mehreren zweiarmigen, in einem Gehäuse auf Bolzen zwischen Anschlägen kippbar gelagerten Greifern.

In der Vakuum-Prozeßtechnik - insbesondere in der Dünnschicht-Technik - ist das Beschichten von kreisscheibenförmigen Substraten, beispielsweise von Glas- oder Aluminiumscheiben für magnetische oder magneto-optische Datenträger bekannt. Diese scheibenförmigen Substrate werden als Speichermedien für digitale Information vielfältig verwendet. In einem Sputterprozeß werden beispielsweise geprägte Kunststoffscheiben mit einer Aluminiumschicht überzogen. Die hierzu eingesetzten Sputter-Beschichtungsanlagen besitzen in aller Regel eine automatisierte Handling-Einrichtung für die Beförderung der Substrate vor, in und hinter einer Vakuum-Kammer.

Von einem Puffer aus transportiert beispielsweise ein Schwenkarm eines Handling-Systems die Substrate in die Vakuum-Kammer. In der Kammer werden dann die Substrate auf einen Drehteller aufgelegt und mit diesem durch die einzelnen Stationen der Vakuum-Kammer hindurchbewegt. Zum Be- und Entladen der Drehteller mit den Substraten sind im Stand der Technik zahlreiche Vorrichtungen zum Greifen und Halten bekannt.

Bisher wurden in den Vakuum-Kammern meist solche Greifer verwendet, die mittels einer Vakuum-Schiebedurchführung von außerhalb der Kammer betätigt werden.

Diese bekannten Vorrichtungen haben den Nachteil, daß sie meist zu viele bewegte Teile enthalten, daß durch die Gleitbewegungen in den Schiebedurchführungen unerwünschte Partikel erzeugt werden, die später in den Beschichtungsraum gelangen und das Beschichtungsergebnis nachteilig beeinflussen. Weiterhin läßt sich bei solchen Schiebedurchführungen in aller Regel nach einer bestimmten Betriebsdauer ein Dichtungsverschleiß feststellen, der immer eine Leckage der Vakuum-Kammer und somit eine zeit- und kostenintensive Reparatur zur Folge hat.

Man hat deshalb bereits eine Vorrichtung vorgeschlagen (DE-U- 93 07 263) zum Greifen und Halten eines flachen, vorzugsweise scheibenförmigen Substrats, im wesentlichen bestehend aus mehreren fingerförmigen Greifern und einer Membran aus elastischem Material, die eine in einem druckfesten Gehäuse angeordnete Öffnung verschließt, wobei auf der Vorder- und Rückseite der Membran unterschiedliche Drücke einstellbar sind und die Membran so angeordnet ist, daß sie bei anliegender Druckdifferenz eine Auslenkung aus ihrer Ruhelage ausführt und bei Druckgleichheit durch eine Druckfeder wieder in ihre Ruhelage zurückstellbar ist und wobei die Greifer mit ihrem jeweils einen Ende mechanisch mit der Membran so verbunden sind, daß sie mit ihrem anderen, freien Ende eine Schwenkbewegung proportional zur Auslenkung der Membran zum Greifen und Halten, beziehungsweise Freigeben des Substrats ausführen.

Man hat ferner bereits eine Vorrichtung zum Greifen und Halten eines flachen, vorzugsweise kreisscheibenförmigen Substrats, beispielsweise einer Compact Disc vorgeschlagen, bestehend aus mehreren fingerförmigen, in einem Gehäuse kippbar gelagerten Greifern, wobei die Greifer in Öffnungen oder Durchbrüchen im Kopfteil des Gehäuses gehalten und geführt sind, die Kippbewegungen der Greifer um Achsen quer zur Längsachse des Gehäuses gestatten, wobei die Kippachsen aller Greifer sich in einer Ebene erstrecken und zusammen ein die Längsachse umschließendes Vieleck bilden, wobei an den dem Substrat abgekehrten Enden der Greifer jeweils Magnete fest angeordnet sind, die mit einem im Gehäuse oberhalb der Magnete vorgesehenen Elektromagneten zusammenwirken, dessen Magnetfeldachse mit der Längsachse des Gehäuses zusammenfällt und der die mit Magneten versehenen Greiferenden je nach Polung des Elektromagneten zwischen zwei Anschlägen hin- und herbewegt.

Der vorliegenden Erfindung liegt die Aufgabe zugrunde, ein System zum Halten eines flachen Substrats mit hoher Betriebssicherheit zu schaffen, das eine besonders schonende Behandlung der Substrate sicherstellt, das preiswert herstellbar ist und eine flache Bauweise ermöglicht.

Diese Aufgabe wird gemäß der Erfindung gelöst durch eine Vorrichtung bestehend aus mehreren zweiarmigen, in Gehäusen auf Bolzen zwischen Anschlägen kippbar gelagerten Greifern, wobei die Längsachsen der Bolzen tangential zu einer sich vertikal erstreckenden kreisförmigen Öffnung einer die Gehäuse tragenden Transportscheibe ausgerichtet und gleichmäßig um die Öffnung verteilt angeordnet sind, deren Durchmesser größer bemessen ist als der Außendurchmesser der Substrate, wobei die Bolzen fest an den Gehäusen gehalten sind und die auf den Bolzen gelagerten Greifer jeweils mit einem Arm in radikaler Richtung zur Öffnung hin um ein bestimmtes Maß in diese hineinragen, wenn der Arm des jeweiligen Greifers sich in einer horizontalen Position befindet, sich jedoch aus dem von der Öffnung begrenzten Bereich herausbewegt, wenn die freien Enden der Arme der Greifer in eine zur Horizontalen geneigte Position verschwenkt werden, wobei jeder der Greifer mit Permanentmagneten versehen ist, die jeweils mit den ungleichnamigen Polen eines in seiner Nachbarschaft am jeweiligen Gehäuse angeordneten Magneten korrespondieren und den Greifer in der horizontalen Position halten, wobei oberhalb der Ebene der Öffnung am Gehäuse ein weiterer Permanentmagnet vertikal bewegbar gelagert ist, der über einen Stößel mit dem Anker eines Elektromagneten verbunden ist, wobei der Abstand des vertikal verschiebbaren Magneten zu einem weiteren Magneten am Greifer so bemessen ist, daß er die Haltekraft der Greifermagneten überwindet, wenn er sich in seiner greifernahen Position befindet, diese jedoch nicht beeinflußt, wenn er sich in der greiferferne Position befindet.

Weitere Einzelheiten und Merkmale sind in den Unteransprüchen beschrieben und gekennzeichnet.

Die Erfindung läßt die verschiedensten Ausführungsmöglichkeiten zu; eine davon ist in den anhängenden Zeichnungen rein schematisch dargestellt, und zwar zeigen:

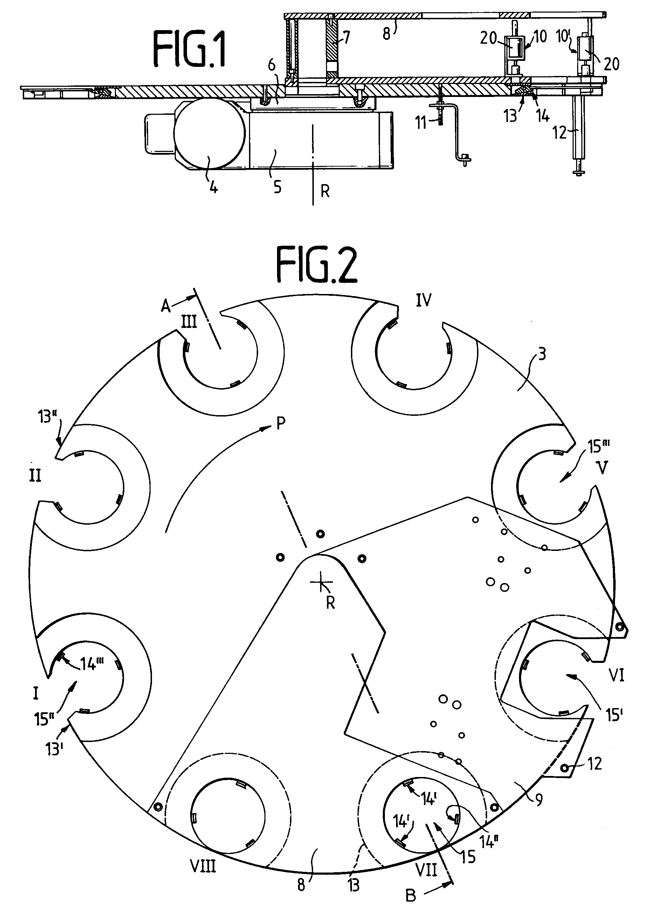

- Fig. 1: ein Transportkarussell mit Antriebsmotor, Getriebe, kreisscheibenförmiger Transportscheibe und mit Montageplatten in der Seitenansicht und teilweise im Schnitt gemäß den Linien A-B nach Fig. 2,
- Fig. 2: die Transportscheibe nach Fig. 1 in der Draufsicht, wobei die Umrißlinien der beiden Montageplatten für eine Trocknungs- und eine Lackiervorrichtung angedeutet sind,
- Fig. 3: einen Teilschnitt quer durch die Transportscheibe mit Greifer und Greiferbetätigung in der Seitenansicht,

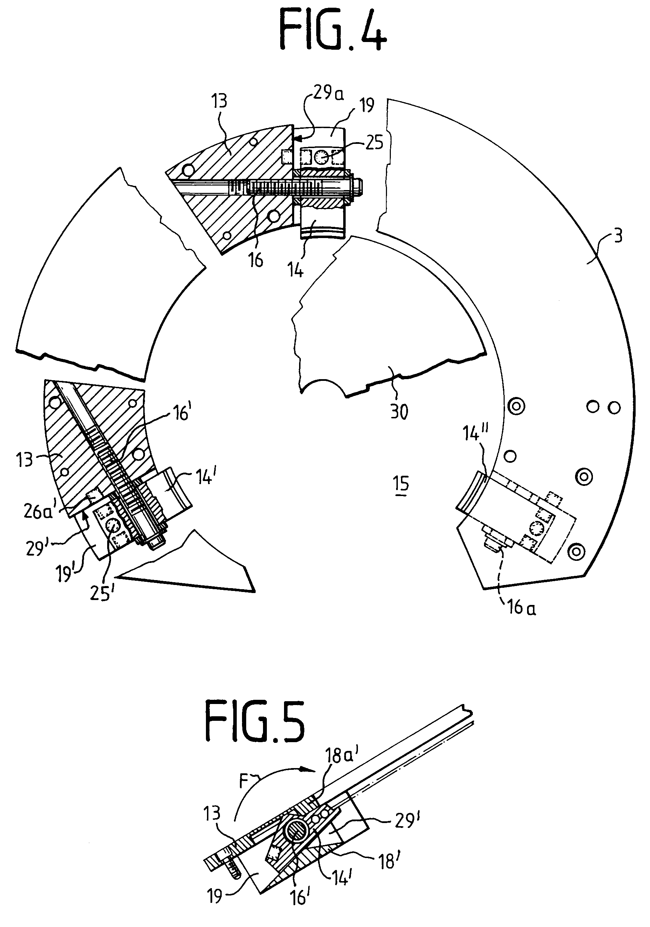

- Fig. 4: den Ausschnitt gemäß Fig. 3 in der Draufsicht,
- Fig. 5: einen Greifer der Anordnung gemäß Fig. 4 in der Seitenansicht und
- Fig. 6 bis 9: einen Greifer in verschiedenen Ansichten und in vergrößerten Darstellungen.

Die Vorrichtung besteht im wesentlichen aus einer kreisscheibenförmigen Transportscheibe 3, einem Antriebsmotor 4 mit Getriebe 5 und Antriebsflansch 6, einem Stützrohr 7 mit zwei an diesem befestigten Montageplatten 8,9, den Greiferbetätigungen 10,10',..., Sensoren 11,11',..., Stützen 12,12',... für die Montageplatte 9 und den kreisringförmigen Gehäusen 13,13',... mit den in diesen kippbar gelagerten Greifern 14,14',...

In der Transportscheibe 3 sind auf ihrem Umfang gleichmäßig verteilt acht kreisförmige Aussparungen oder Öffnungen 15,15',... angeordnet, die jeweils von kreisringförmig ausgeformten, an einer Seite offenen Gehäusen 13,13',... umschlossen sind, in denen jeweils drei Greifer 14,14', 14'',... auf Bolzen 16,16',... zwischen Anschlägen 18,18a; 18',18a'; ... gelagert sind, und zwar in Ausnehmungen 19,19',..., die in den Gehäusen 13,13',... vorgesehen sind. Auf einer ortsfesten Stützplatte 17 oberhalb der Transportscheibe 3 sind jeweils oberhalb der Greifer 14,14',... Greiferbetätigungen 10,10',... befestigt, die jeweils mit einem Elektromagneten 20,20',... ausgestattet sind, die jeweils über einen Stößel 21,21',... einen Permanentmagneten 22,22',... auf- bzw. abwärts bewegen können.

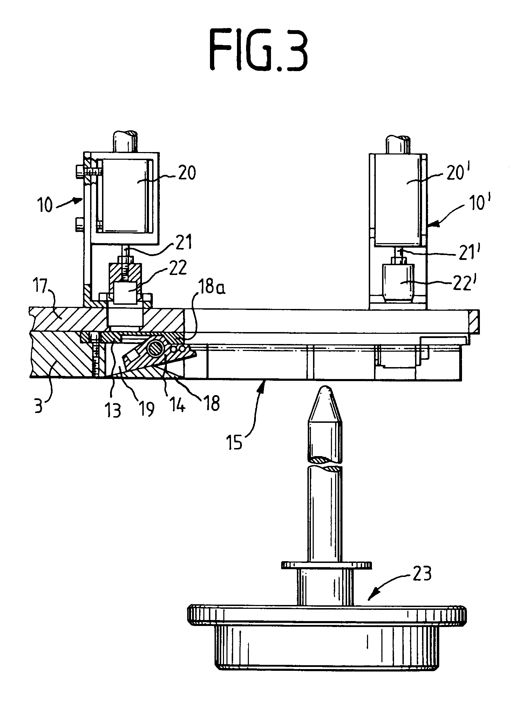

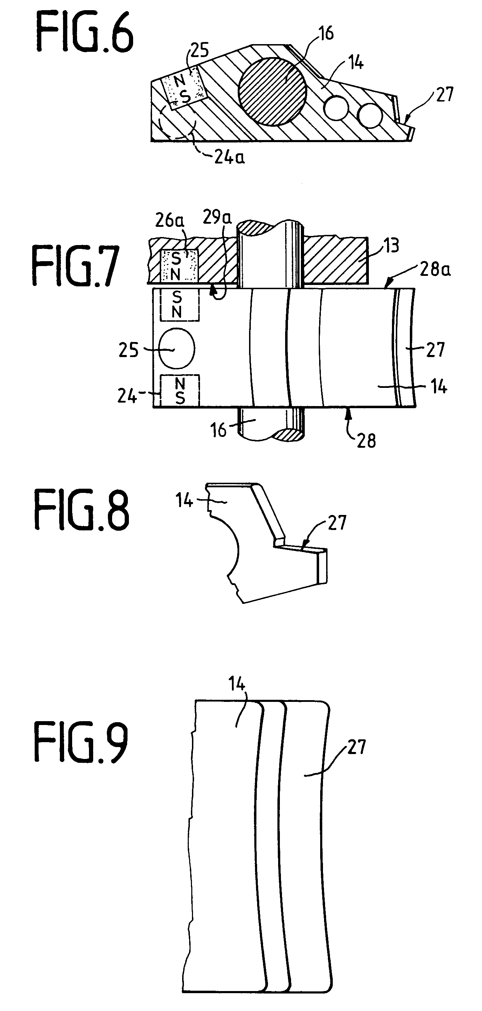

Wenn sich die Transportscheibe 3 in Pfeilrichtung P dreht und die Substrate (die compact disc's) 30 in der Position I aufgenommen werden, in dem sie von einem (nicht dargestellten) Handlingarm in die Aussparung 15'' eingelegt werden, so daß die Substrate 30 jeweils auf den drei einer Öffnung 15,15',... zugeordneten Greifern 14''',... mit ihren radial äußeren Randpartien aufliegen, dann kann das jeweilige Substrat 30 durch Weiterdrehen der Transportscheibe 3 in Schritten um jeweils 45° Drehwinkel in Schritten von Station zu Station weiterbefördert werden, bis das Substrat schließlich die Station VIII erreicht hat und dort dadurch aus seiner Halterung gelöst wird, daß die drei sie haltenden Greifer 14,... von der in Fig. 3 bzw. 5 dargestellten Position gleichzeitig in Pfeilrichtung F nach unten geschwenkt werden und dadurch aus dem Bereich des scheibenförmigen Substrats gelangen und dieses auf die Substrataufnahme 23 fallen lassen (Fig. 3).

Die Schwenkbewegung der Greifer 14,14',... wird dadurch bewirkt, daß der Permanentmagnet 22,22',... vom jeweils zugeordneten Elektromagneten 20,20',... abwärts bewegt wird, wobei der Permanentmagnet 22,22',... den Magneten 25,25',... anzieht, wozu sich verschiedennamige Pole gegenüberliegen, d.h. daß z.B. der unten liegende Pol des Magneten 22 ein Südpol ist und der oben liegende Pol des Magneten 25,25' ein Nordpol ist. Da jeder Greifer 14,14',... neben einem mit dem Magneten 22,22',... korrespondierenden Magneten 25,25',... noch zwei weitere Permanentmagneten 24,24a bzw. 24',24a',... aufweist, die mit Magneten korrespondieren bzw. von Magneten angezogen werden, die im Gehäuse 13,13',... angeordnet sind, und zwar derart, daß diese Magneten unmittelbar neben den Magneten 24,24a,... liegen, wenn die Greifer 14,14',... jeweils die in den Figuren 3 und 5 dargestellte Stellung (Sperrstellung) einnehmen. Die Greifer 14,14',... werden also jeweils von den Magneten 24,26,... bzw. 24a,26a,... in der Sperrstellung gehalten und können dann durch Absenken der Magnete 22,22',... aus dieser Stellung entgegen der Pfeilrichtung F (Fig. 5) in die Lösestellung gekippt werden, wozu jeweils der Elektromagnet 20,20',... der jeweiligen Greiferbetätigung 10,10',... elektrisch angesteuert wird. Die zweiarmigen Greifer 14,14',... selbst sind jeweils an den einander zugekehrten Enden mit Greifernasen 27,27',... versehen, auf deren oberer Seite in der Haltestellung jeweils die Randpartie eines Substrats 30 aufliegt.

### Bezugszeichenliste

- 3: Transportscheibe, Transportplatte
- 4: Antriebsmotor
- 5: Getriebe
- 6: Antriebsflansch
- 7: Stützrohr
- 8: Montageplatte
- 9: Montageplatte
- 10,10',...: Greiferbetätigung
- 11,11',...: Sensor
- 12,12': Stütze
- 13,13',...: kreisringförmiges Gehäuse, Gehäusering
- 14,14',...: Greifer
- 15,15',...: Aussparung, Öffnung
- 16,16',...: Bolzen
- 17: Stützplatte
- 18,18a;18',18a',...: Anschlag
- 19,19',...: Ausnehmung
- 20,20',...: Elektromagnet
- 21,21',...: Stößel
- 22,22',...: Permanentmagnet
- 23: Substrataufnahme
- 24,24a,...: Magnet, Permanentmagnet
- 25,25',...: Magnet, Permanentmagnet
- 26,26',...: Magnet, Permanentmagnet
- 27,27',...: Nase, Vorderkante
- 28,28',...: Seitenfläche
- 29,29',...: Seitenfläche
- 30: Substrat

## Patentansprüche

1. Vorrichtung zum Halten eines flachen, vorzugsweise kreisscheibenförmigen Substrats (30,30',...) mit einer zentralen Öffnung, einer sogenannten compact disc, bestehend aus mehreren zweiarmigen, in Gehäusen (13,13',...) auf Bolzen (16,16',...) zwischen Anschlägen (18',18a';...) kippbar gelagerten, als zweiarmige Hebel ausgebildeten Greifern (14,14',...), wobei die Längsachsen der Bolzen tangential zu einer sich vertikal erstreckenden, kreisförmigen, die Substrate umschließenden Öffnung (15,15',...) einer die Gehäuse tragenden Transportscheibe (3) ausgerichtet und gleichmäßig um die Öffnung verteilt angeordnet sind, deren Durchmesser größer bemessen ist als der Außendurchmesser der Substrate, wobei die Bolzen fest an den Gehäusen gehalten sind und die auf den Bolzen gelagerten Greifer jeweils mit einem Arm in radialer Richtung zur Mitte der Öffnung hin um ein bestimmtes Maß in diese hineinragen, wenn der Arm des jeweiligen Greifers sich in einer ersten horizontalen Position befindet, sich jedoch aus dem von der Öffnung begrenzten Bereich herausbewegt, wenn die freien Enden der Arme der Greifer in eine zur Horizontalen geneigte zweite Position verschwenkt werden, wobei jeder der Greifer mit Permanentmagneten (24,24a;...) versehen ist, die jeweils mit den ungleichnamigen Polen eines in seiner Nachbarschaft am jeweiligen Gehäuse angeordneten Magneten (26,26a,...) korrespondieren und den Greifer in der horizontalen Position halten, wobei oberhalb der Ebene der Öffnung am Gehäuse ein weiterer Permanentmagnet (22,22',...) vertikal bewegbar gelagert ist, der über einen Stößel (21,21',...) mit dem Anker eines Elektromagneten (20,20',...) verbunden ist, wobei der Abstand des vertikal verschiebbaren Magneten zu einem weiteren Magneten (25,25',...) am Greifer so bemessen ist, daß er die Haltekraft der Greifermagneten überwindet, wenn er sich in seiner greifernahen Position befindet, diese jedoch nicht beeinflußt, wenn er sich in der greiferfernen Position befindet.

2. Vorrichtung nach Anspruch 1, **dadurch gekennzeichnet**, daß die als zweiarmige Hebel ausgeformten Greifer (14,14',...) an ihren der Öffnung (15,15',...) abgekehrten Enden mit jeweils einem Magneten (24,24a;...) im Bereich seiner Seitenflächen (28,28a;...) versehen ist, wobei jedem der Magnete (24,24a;...) ein korrespondierender Magnet (26,26a;...) in den Seitenflächen (29,29a;...) der entsprechenden Ausnehmung (19,19',...) im Gehäuse (13,13',...) zugeordnet ist, wobei die Magnete so bemessen sind, daß der Greifer (14,14',...) in einer horizontalen Stellung verharrt und in dieser das an seinem radial auf die Öffnung (15,15',...) zu ausgerichteten Arm abgestützte Substrat (30,30',...) untergreift.

3. Vorrichtung nach den Ansprüchen 1 und 2, **dadurch gekennzeichnet**, daß jeweils an dem der Öffnung (15,15',...) abgekehrten Ende des Greifers (14,14',...) an seiner Oberseite ein Permanentmagnet (25,25',...) fest angeordnet ist, der jeweils mit einem weiteren Magneten (22,22',...) korrespondiert, der auf einer sich in einer zur Transportscheibe (3) parallelen Ebene erstreckenden Stützplatte (17) in vertikaler Richtung bewegbar von einem Stößel (21,21',...) gehalten und geführt ist.

4. Vorrichtung nach den Ansprüchen 1 bis 3, **dadurch gekennzeichnet**, daß die auf der ortsfesten Stützplatte (17) befestigten Greiferbetätigungen (10,10',...) in einem solchen Abstand zueinander und von der Rotationsachse (R) der Transportscheibe (3) entfernt angeordnet sind, daß in bestimmten Stationen (VI, VII, VIII) jeweils die einer Öffnung (15,15',...) zugeordneten Greifer (14,14',...) gleichzeitig durch Absenken der Magnete (22,22',...) der Greiferbetätigungen (10,10',...) der jeweiligen Station (VI, VII, VIII) ankippbar sind.

5. Vorrichtung nach einem oder mehreren der vorhergehenden Ansprüche, **dadurch gekennzeichnet**, daß die Transportplatte oder Transportscheibe (3) zum Fördern der Substrate (30,30',...) durch die einzelnen Stationen (I,II,...) um eine vertikale Drehachse (R) oder entlang eines Förderpfades bewegbar ist und mit einer oder mehreren Öffnungen (15,15',...) zur Aufnahme von Substraten (30,30',...) versehen ist, wobei jeder Öffnung zwei oder mehr Greifer (14,14',...) zugeordnet sind und die einer Station (I,II,...) zugeordneten Greiferbetätigungen auf einer oberhalb der Transportplatte oder Transportscheibe (3) ortsfest gehaltenen Montageplatte (8) oder auf dem Maschinengestell unterhalb der bewegbaren Transportplatte oder Transportscheibe (3) gehalten sind.

## Claims

1. A device for retaining a flat, preferably circular disc-shaped substrate (30, 30',...) with a central opening, a so-called compact disc, comprising a plurality of two-arm grippers (14, 14',...), which are mounted in housings (13, 13',...) on bolts (16, 16',...) so as to tilt between abutments (18', 18a';...) and are constructed as two-arm levers, the longitudinal axes of the bolts being aligned tangentially to a vertically extending, circular opening (15, 15',...) enclosing the substrates and formed in a transportation disc (3) supporting the housing, and being uniformly distributed around the opening, whose diameter is larger than the external diameter of the substrates, the bolts being fixedly secured to the housing and the grippers mounted on the bolts projecting with an arm in each case in the radial direction towards the centre of the opening into the opening by a given degree when the arm of the respective gripper is located in a first horizontal position, but moving out of the region defined by the opening when the free ends of the arms of the grippers are pivoted into a second position inclined relative to the horizontal, each of the grippers being provided with permanent magnets (24, 24a;...), which correspond respectively to the opposite poles of a magnet (26, 26a,...) arranged in the vicinity of the gripper on the respective housing and hold the gripper in the horizontal position, a further permanent magnet (22, 22',...) being mounted on the housing above the plane of the opening so as to be vertically displaceable and being connected via a pushrod (21, 21',...) to the armature of an electromagnet (20, 20',...), the distance of the vertically displaceable magnet from a further magnet (25, 25',...) on the gripper being dimensioned so that the vertically displaceable magnet overcomes the retaining force of the gripper magnet when the vertically displaceable magnet is located in its position near the gripper, but does not influence said retaining force when it is located in the position remote from the gripper.

2. A device according to claim 1, characterised in that the gripper (14, 14',...) constructed as a two-arm lever is provided at its ends remote from the opening (15, 15') with a magnet (24, 24a;...) in each case in the region of its lateral faces (28, 28a;...), each of the magnets (24, 24a;...) being associated with a corresponding magnet (26, 26a;...) in the lateral faces (29, 29a;...) of the corresponding recess (19, 19',...) in the housing (13, 13',...), the magnets being dimensioned in such a manner that the gripper (14, 14',...) remains in a horizontal position and in this position engages underneath the substrate (30, 30',...) supported on its arm pointing radially towards the opening (15, 15',...).

3. A device according to claims 1 and 2, characterised in that a permanent magnet (25, 25',...) is fixedly arranged at each end of the gripper (14, 14',...) remote from the opening (15, 15',...) on the upper side of the gripper (14, 14',...), which permanent magnet corresponds to a further magnet (22, 22',...), which is held and guided by a pushrod (21, 21',...) so as to be displaceable in the vertical direction in a support plate (17) extending in a plane parallel to the transportation disc (3).

4. A device according to claims 1 to 3, characterised in that the gripper actuating devices (10, 10',...) secured to the stationary support plate (17) are arranged at such a distance from one another and from the axis of rotation (R) of the transportation disc (3) that, in given stations (VI, VII, VIII), the respective grippers (14, 14',...) associated with an opening (15, 15',...) can be simultaneously tilted by lowering the magnets (22, 22',...) of the gripper actuating devices (10, 10',...) of the respective station (VI, VII, VIII).

5. A device according to one or more of the preceding claims, characterised in that the transportation plate or transportation disc (3) is displaceable about the vertical axis of rotation (R) or along a conveying path in order to convey the substrates (30, 30',...) through the individual stations (I, II,...) and is provided with one or more openings (15, 15',...) for receiving substrates (30, 30',...), two or more grippers (14, 14',...) being associated with each opening and the gripper actuating devices associated with a station (I, II,...) being held on a mounting plate (8), which is held in place above the transportation plate or transportation disc (3), or being held on the machine frame beneath the displaceable transportation plate or transportation disc (3).

## Revendications

1. Dispositif pour maintenir un substrat plat de préférence en forme de disque circulaire (30, 30',...) présentant une ouverture centrale, ou soi-disant "disque compact", constitué par plusieurs griffes (14, 14', ...) à deux bras, montées en pivotement entre des butées (18', 18a' ; ...) dans des carters (13, 13', ...) sur des goujons (16, 16', ...) et réalisées sous forme de leviers à deux bras,
dans lequel
- les axes longitudinaux des goujons sont orientés tangentiellement à une ouverture (15, 15', ...), s'étendant verticalement, en forme circulaire et entourant les substrats, d'un disque transporteur (3) portant les carters, et sont agencés en répartition régulière autour de l'ouverture, dont le diamètre est dimensionné plus grand que le diamètre extérieur des substrats,
- les goujons sont maintenus fermement sur les carters, et les griffes montées sur les goujons pénètrent chacune par un bras en direction radiale vers le centre de l'ouverture d'une certaine distance, lorsque le bras de la griffe respective se trouve dans une première position horizontale, mais se déplace hors de la zone limitée par l'ouverture lorsque les extrémités libres des bras des griffes sont pivotées dans une seconde position inclinée par rapport à l'horizontale,
- chacune des griffes est pourvue d'aimants permanents (24, 24a ; ...) qui correspondent chacun aux pôles de nom contraire d'un aimant (26, 26a, ...) agencé à son voisinage sur le carter respectif et qui maintiennent la griffe dans la position horizontale,
- au-dessus du plan de l'ouverture sur le carter est monté un autre aimant permanent (22, 22', ...) en déplacement vertical, qui est relié via un poussoir (21, 21', ...) à l'induit d'un électro-aimant (20, 20', ...), la distance de l'aimant en déplacement vertical par rapport à un autre aimant (25, 25', ...) sur la griffe étant dimensionnée telle qu'il surmonte la force de maintien de l'aimant de la griffe lorsqu'il se trouve dans sa position proche de la griffe, mais qu'il n'influence pas cette force lorsqu'il se trouve dans la position éloignée de la griffe.

2. Dispositif selon la revendication 1, caractérisé en ce que les griffes (14, 14', ...) réalisées sous forme de leviers à deux bras sont pourvues, à leurs extrémités détournées de l'ouverture (15, 15', ...), d'un aimant respectif (24, 24a ; ...) dans la zone de ses surfaces latérales (28, 28a ; ...), à chacun des aimants (24, 24a ; ...) étant associé un aimant correspondant (26, 26a ; ...) dans les surfaces latérales (29, 29a ; ...) de l'évidement correspondant (19, 19', ...) dans le carter (13, 13', ...), les aimants étant dimensionnés tels que la griffe (14, 14', ...) demeure dans une position horizontale et engage dans cette position par le dessous le substrat (30, 30', ...) appuyé sur son bras dirigé radialement vers l'ouverture (15, 15', ...).

3. Dispositif selon les revendications 1 et 2, caractérisé en ce que sur l'extrémité respective, détournée de l'ouverture (15, 15', ...), de la griffe (14, 14', ...) est fermement agencé, sur sa face supérieure, un aimant permanent (25, 25', ...) qui correspond à un autre aimant respectif (22, 22', ...) qui est maintenu et guidé en déplacement en direction verticale par un poussoir (21, 21', ...) sur une plaque d'appui (17) s'étendant dans un plan parallèle au disque transporteur (3).

4. Dispositif selon les revendications 1 à 3, caractérisé en ce que les éléments d'actionnement de griffe (10, 10', ...) fixés sur la plaque d'appui stationnaire (17) sont agencés à une telle distance entre eux et par rapport à l'axe de rotation (R) du disque transporteur (3), que dans certaines stations (VI, VII, VIII) les griffes (14, 14', ...) associées respectivement à une ouverture (15, 15', ...) sont susceptibles d'être amenées à pivoter simultanément par abaissement des aimants (22, 22', ...) des éléments d'actionnement de griffe (10, 10', ...) des stations respectives (VI, VII, VIII).

5. Dispositif selon l'une ou plusieurs des revendications précédentes, caractérisé en ce que, pour transporter les substrats (30, 30',...) à travers les stations individuelles (I, II, ...), la plaque de transport ou disque transporteur (3) est déplaçable autour d'un axe de rotation vertical (R) ou le long d'un trajet de transport et pourvu(e) d'une ou de plusieurs ouvertures (15, 15', ...) pour recevoir les substrats (30, 30', ...), à chaque ouverture étant associées deux ou plusieurs griffes (14, 14', ...), et les éléments d'actionnement de griffe associés à une station (I, II, ...) étant maintenus sur une plaque de montage (8) maintenue solidairement au-dessus de la plaque de transport ou du disque transporteur (3) ou sur le bâti de machine au-dessous de la plaque de transport ou disque transporteur déplaçable (3).
